(19) Europäisches Patentamt / European Patent Office / Office européen des brevets

(11) **EP 2 919 276 B1**

(12) **EUROPÄISCHE PATENTSCHRIFT**

(45) Veröffentlichungstag und Bekanntmachung des Hinweises auf die Patenterteilung:
**10.07.2019 Patentblatt 2019/28**

(51) Int Cl.:
**H01L 31/0687** *(2012.01)*    **H01L 31/0304** *(2006.01)*
**H01L 21/18** *(2006.01)*

(21) Anmeldenummer: **14000912.7**

(22) Anmeldetag: **13.03.2014**

(54) **Mehrfach-Solarzelle**

Multijunction solar cell

Cellule solaire à jonctions multiples

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.09.2015 Patentblatt 2015/38**

(73) Patentinhaber: **AZUR SPACE Solar Power GmbH 74072 Heilbronn (DE)**

(72) Erfinder:
- **Guter, Wolfgang**
  **70190 Stuttgart (DE)**
- **Meusel, Matthias**
  **74076 Heilbronn (DE)**
- **Dimroth, Frank**
  **79115 Freiburg (DE)**
- **Ebel, Lars**
  **97249 Eisingen (DE)**
- **Kellenbenz, René**
  **74076 Heilbronn (DE)**

(74) Vertreter: **Koch Müller Patentanwaltsgesellschaft mbH Maaßstraße 32/1 69123 Heidelberg (DE)**

(56) Entgegenhaltungen:
EP-A2- 0 353 423    US-A1- 2012 138 130
US-A1- 2012 240 987

- A.W. BETT ET AL.: "Highest Efficiency Multi-Junction Solar Cell for Terrestrial and Space Applications", PROCEEDINGS OF THE 24TH EUROPEAN PHOTOVOLTAIC SOLAR ENERGY CONFERENCE AND EXHIBITION, 21. September 2009 (2009-09-21), - 25. September 2009 (2009-09-25), Seiten 1-6, XP040529663, Hamburg-Germany DOI: 10.4229/24thEUPVSEC2009-1AP.1.1 ISBN: 978-3-936338-25-6
- FRIEDMAN D J ET AL: "0.7-eV GaInAs Junction for a GaInP/GaAs/GaInAs(1eV)/GaInAs(0.7eV) Four-Junction Solar Cell", CONFERENCE RECORD OF THE 2006 IEEE 4TH WORLD CONFERENCE ON PHOTOVOLTAIC ENERGY CONVERSION (IEEE CAT. NO.06CH37747), IEEE, Mai 2006 (2006-05), Seiten 598-602, XP031041745, DOI: 10.1109/WCPEC.2006.279527 ISBN: 978-1-4244-0016-4
- DIMROTH F ET AL: "METAMORPHIC GAYIN1-YP/GA1-XINXAS TANDEM SOLAR CELLS FOR SPACE AND FOR TERRESTRIAL CONCENTRATOR APPLICATIONS AT C>1000 SUNS", PROGRESS IN PHOTOVOLTAICS: RESEARCH AND APPLICATIONS, JOHN WILEY & SONS, LTD, Bd. 9, Nr. 3, Mai 2001 (2001-05), Seiten 165-178, XP008060557, ISSN: 1062-7995, DOI: 10.1002/PIP.362
- TAKUO SASAKI ET AL: "Real-Time Structural Analysis of Compositionally Graded InGaAs/GaAs(0 0 1) Layers", IEEE JOURNAL OF PHOTOVOLTAICS, I E E E, US, Bd. 2, Nr. 1, 30. Januar 2012 (2012-01-30) , Seiten 35-40, XP011393492, ISSN: 2156-3381, DOI: 10.1109/JPHOTOV.2011.2174198

• Jan Schone: "Kontrolle von Spannungsrelaxation und Defektbildung in metamorphen III-V Halbleiterheterostrukturen für hocheffiziente Solarzellen", Dissertation, 21 July 2009 (2009-07-21), pages 1-146, XP055528372, Retrieved from the Internet: URL:https://d-nb.info/1019870907/34 [retrieved on 2018-11-29]

• W. GUTER ET AL: "Investigation and development of III-V Triple-Junction Concentrator Solar Cells", PROCEEDINGS OF THE 22ND EUROPEAN PHOTOVOLTAIC SOLAR ENERGY CONFERENCE, 3 September 2007 (2007-09-03), - 7 September 2007 (2007-09-07), pages 122-125, XP040512959, Milan-Italy ISBN: 978-3-936338-22-5

**Beschreibung**

Die Erfindung betrifft eine Mehrfach-Solarzelle gemäß dem Oberbegriff des Patentanspruchs 1.

Aus der Druckschrift "Current-matched triple-junction solar cell reaching 41.1% conversion efficiency under concentrated sunlight" von Guter et al., Applied Physics Letters 94, 223504 (2009)] ist eine Mehrfach-Solarzelle (engl. multi-junction solar cell) bekannt. Bei der offenbarten Struktur handelt es sich um eine metamorphe $Ga_{0.35}In_{0.65}P/Ga_{0.83}In_{0.17}As/Ge$ Dreifach-Solarzelle mit hohem Wirkungsgrad. Zwischen dem Ge Substrat bzw. der Ge Teilzelle und der $Ga_{0.83}In_{0.17}As$ Teilzelle wird hier ein metamorpher Puffer aus $Ga_YIn_{1-Y}As$ verwendet. Der metamorphe Puffer besteht hier aus sieben 200 nm dicken GaInAs Schichten mit schrittweise ansteigendem Indium-Gehalt, wobei sich gleichzeitig auch die Gitterkonstante erhöht. In der letzten Schicht des Puffers, der so genannten Überschuss-Schicht (engl. overshoot), wird hier ein größerer Indium-Gehalt von 20% bzw. eine größere Gitterkonstante als in der darüber liegenden $Ga_{0.83}In_{0.17}As$ Teil-Zelle verwendet. Dies ist notwendig, um die Verspannung aufzubauen, welche zur Relaxation der darunterliegenden Schichten des metamorphen Puffers auf die gewünschte Gitterkonstante führt.

Aus der US 2012 / 240 987 A1 und aus " Bett A. W.et al.: "HIGHEST EFFICIENCY MULTI-JUNCTION SOLAR CELL FOR TERRESTRIAL AND SPACE APPLICATIONS", Proceedings of the 24th European Photovoltaic Solar Energy Conference and Exhibition, 21-25 September 2009, Seiten 1-6, Hamburg, Germany, ISBN: 978-3-9363338-25-6 und der US 2012 / 138 130 A1 und aus Friedman D J et al: "0.7-eV GaInAs junction for a GaInP/GaAs/GaInAs(1eV)/GaIn-As(0.7eV) four-junction solar cell", Conference record of the 2006 IEEE 4th world conference on photovoltaic energy conversion, IEEE, Mai 2006, Seiten 598-602, ISBN: 978-1-4244-0016-4 und aus Dimroth F. et al: Metamorphic GayIn1-yP/Ga1-xInxAs tandem solar cells for space and for terrestrial concentrator applications at C > 1000 suns, Progress in Photovoltaics: Research and Applications, John Wiley & Sons, LTD, Bd. 9, Nr. 3, Mai 2001, Seiten 165-178, ISSN: 1062-7995 und aus Takuo Sasaki et al: "Real-Time structural 1,6 Analysis of compositionally graded InGaAs / GaAs (0 0 1) Layers", IEEE Journal of photovoltaics, Bd. 2 Nr. 1, 30 Januar 2012, Seiten 35-40, ISSN: 2156-3381, und der EP 0 353 432 A2 und aus "Investigation and development of III-V triple-junction concentrator solar cells", W. Guter et al, Proceedings of the 22nd European Photovoltaic Solar Energy Conference, 2007, pp. 122-125, XP040512959, Milan-Italy, ISBN: 978-3-936338-22-5 und aus "Kontrolle von Spannungsrelaxation und Defektbildung in metamorphen III-V Halbleiterheterostrukturen für hocheffiziente Solarzellen", Jan Schöne, Dissertation, 2009, pp. 1-146, XP 055528372 sind Mehrfachsolarzellen teilweise mit metamorphen Puffern bekannt.

Weiterhin ist aus der Druckschrift "Evolution of a 2.05 eV AlGaInP top sub-cell for 5 and 6J-IMM applications" von Cornfield et al., Seite, 2788 - 2791, in: Photovoltaic Specialists Conference (PVSC), 2012 38th IEEE, ISBN: 978-1-4673-0064-3, eine Ausbildung von metamorphen Puffern in invertierten Mehrfach-Solarzellen (engl. inverted metamorphic, IMM) mit bis zu sechs Teilzellen bekannt. Ferner ist aus der EP 225 1912 A1 eine Tunneldiodenstruktur mit unterschiedlich verspannten Schichten und mehreren Solarzellen und einem metamorphen Puffer bekannt.

Aus EP 265 093 0 A1 ist eine Vierfach-Solarzelle bestehend aus einer oberen GaInP/GaAs Zweifach-Solarzelle gefügt (engl. bonded) auf eine untere metamorphe GaInAs/Ge Zweifach-Solarzelle bekannt.

Zur Vollständigkeit sei angemerkt, dass vorliegend mit dem Begriff metamorphe Mehrfach-Solarzelle, Mehrfach-Solarzellen verstanden werden, die wenigstens eine metamorphe Pufferschicht zwischen zwei Teilzellen (engl. sub-cell) des Solarzellenstapels aufweisen. Des Weiteren sei angemerkt, dass bei der Epitaxie von III-V Mehrfach-Solarzellen so genannte metamorphe Puffer verwendet werden, um auf diesen Puffern Halbleiterschichten mit hoher Qualität aus Materialien mit größerer Gitterkonstante als die des Substrates abscheiden zu können. Durch den metamorphen Puffer wird also im Verlauf der Epitaxie ein so genanntes virtuelles Substrat mit größerer Gitterkonstante als der des ursprünglichen Substrates gebildet. Halbleiterschichten mit der gleichen Gitterkonstante wie die des virtuellen Substrates können im Folgenden mit hoher Qualität abgeschieden werden. Mit dem Einsatz der metamorphen Puffer wird ein größerer Spielraum bei der Wahl der Materialien für die verschiedenen Teilzellen bei den Mehrfach-Solarzellen ermöglicht. Insbesondere lassen sich hierdurch Materialkombinationen realisieren, welche einen höheren Wirkungsgrad der Mehrfach-Solarzelle versprechen.

Ein Problem bei der Verwendung von den metamorphen Puffern ist die inhärente Restverspannung. Je nach Flexibilität des verwendeten Substrates führt die Restverspannung zu einer unerwünschten Krümmung der Halbleiterscheibe (engl. wafer) Insbesondere bei der Herstellung auf den üblichen Ge Substraten mit einer Dicke kleiner 190 $\mu$m ergeben sich z.B. signifikante Krümmungseffekte.

Eine Krümmung der Halbleiterscheibe führt unter anderem bereits während der Epitaxie aufgrund von Temperatureffekten zu inhomogenen Schichteigenschaften. Weiterhin wird die Verarbeitung derartiger Halbleiterscheiben erschwert und reduziert die Ausbeute und erhöht hierdurch die Herstellungskosten deutlich. Ferner führt eine Krümmung bei Raumfahrt-Solarzellen mit typischen Flächen größer 20 $cm^2$ zu unerwünschten Produkteigenschaften.

Vor diesem Hintergrund besteht die Aufgabe der Erfindung darin, eine Vorrichtung anzugeben, die den Stand der Technik weiterbildet.

Die Aufgabe wird durch eine Mehrfach-Solarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Mehrfach-Solarzelle bereitgestellt, aufweisend Mehrfach-Solarzelle aufweisend eine erste Teilzelle aus einer Verbindung aus InGaAs, wobei die erste Teilzelle eine erste Gitterkonstante aufweist, und eine zweite Teilzelle mit einer zweiten Gitterkonstanten vorgesehen ist, wobei die erste Gitterkonstante um mindestens 0,008 Å größer ist als die zweite Gitterkonstante, und des Weiteren ein metamorpher Puffer vorgesehen ist, wobei der Puffer zwischen der ersten Teilzelle und der zweiten Teilzelle ausgebildet ist, und der metamorphe Puffer eine Abfolge von mindestens drei Schichten aufweist und die Gitterkonstante bei der Abfolge in Richtung zu der ersten Teilzelle von Schicht zu Schicht ansteigt und wobei die Gitterkonstanten der Schichten des Puffers größer als die zweite Gitterkonstante sind und wobei eine Schicht des metamorphen Puffers eine dritte Gitterkonstante aufweist und die dritte Gitterkonstante größer als die erste Gitterkonstante ist, und zwischen dem metamorphen Puffer und der ersten Teilzelle eine Anzahl N von Kompensationsschichten zur Kompensation der Restverspannung des metamorphen Puffers ausgebildet sind und die Gitterkonstanten der jeweiligen Kompensationsschichten um einen Betrag von $\Delta A_N$ >0,0008 Å kleiner als die erste Gitterkonstante sind, und die Kompensationsschichten ein Indiumgehalt größer als 1% aufweisen, und die Dicken der Anzahl N der Kompensationsschichten so gewählt sind, dass gilt:

$$\sum_{n=1}^{N} (KOMD_n \times \Delta A_n) > 10^{-19} \, m^2$$

Es sei angemerkt, dass ein tensiler Stress zu einer konvexen Krümmung und entsprechend ein kompressiver Stress zu einer konkaven Krümmung des Halbleitersubstrates bzw. der Halbleiterscheibe führt und die Mehrfach-Solarzelle bevorzugt aus einem III-V Halbleitermaterial besteht. Hierbei wird unter dem Begriff des tensilen Stresses eine Zugspannung und unter dem Begriff des kompressiven Stresses eine Druckspannung verstanden. Des Weiteren sei angemerkt, dass die Anzahl N, die Menge der natürlichen Zahlen ohne die Null umfasst oder anders ausgedrückt, dass wenigstens eine Kompensationsschicht ausgebildet ist.

Ein Vorteil der Ausbildung einer Kompensationsschicht oder mehrerer Kompensationsschichten ist, dass sich hierdurch eine Krümmung der Halbleiterscheibe, insbesondere verursacht durch den metamorphen Puffer, deutlich reduzieren lässt. Untersuchungen haben gezeigt, dass sich durch die Einführung der Kompensationsschicht die Ausbeute bei der Herstellung der Mehrfach-Solarzelle erhöht und die Herstellungskosten reduzieren lassen. Weiterhin ist es vorteilhaft, die Kompensationsschicht nach der letzten Schicht des metamorphen Puffers und vorzugsweise vor der Abscheidung der folgenden Teilzelle auszubilden. Anders ausgedrückt, es ist vorteilhaft, die Kompensationsschicht nach der sogenannten "overshoot" Schicht des Puffers auszubilden. Hierbei besteht zum Beispiel eine aus Sicht eines niedrigen Materialverbrauchs vorteilhafte Ausformung darin, die Kompensationsschicht stoffschlüssig mit der letzten Schicht des metamorphen Puffers zu verbinden. Ferner sei angemerkt, dass gemäß der oben angeführten Formel die Größe der Kompensation als die Größe der Rückführung der Verspannung unmittelbar von dem Unterschied in der Gitterkonstante der Kompensationsschicht im Vergleich zu der ersten Gitterkonstante multipliziert mit der Dicke der Kompensationsschicht abhängt. Untersuchungen der Anmelder haben gezeigt, dass ein gewisses Maß an Kompensationsspannung notwendig ist, um eine signifikante Reduktion der Waferkrümmung zu erzielen. Wünschenswert ist es, eine Reduktion der Verspannung um mindestens 20% zu erreichen.

Zur Vollständigkeit sei angemerkt, dass die Gitterkonstante einer Teilzelle mit der Gitterkonstante einer dicksten Schicht der Teilzelle gleichgesetzt ist. Typischer Weise handelt es sich bei der dicksten Schicht der Teilzelle um eine der Absorberschichten der Teilzelle. Bei industriellen Mehrfachsolarzellen, welche üblicher Weise eine n-auf-p Polarität aufweisen, ist die dickste Schicht typischer Weise die positiv dotierte Basis-Schicht des pn-Übergangs der jeweiligen Teilzelle.

Weiterhin hat das Einfügen der Spannungskompensationsschichten den Vorteil, dass die Gitterkonstante des durch den metamorphen Puffer gebildeten sogenannten virtuellen Substrates nach Abscheidung der Spannungskompensationsschichten weitgehend "eingefroren" ist. Ohne die Spannungskompensationsschichten können unbeabsichtigte Abweichungen bzw. Produktionsschwankungen in der Komposition der im Folgenden abgeschiedenen Schichten, insbesondere der relativ dicken Absorberschichten der Teilzellen, zu weiterer kompressiver Verspannung und hierdurch zu weiterer Relaxation der Schichten des metamorphen Puffers führen. Dies würde eine unerwünschte Vergrößerung der Gitterkonstante des virtuellen Substrates bedeuten. Durch Einfügen der Spannungskompensationsschichten lässt sich jedoch die Restverspannung des metamorphen Puffers stark reduzieren, sodass die Wahrscheinlichkeit einer unbeabsichtigten weiteren Relaxation des metamorphen Puffers deutlich gesenkt wird. Somit ermöglicht das Einfügen der Spannungskompensationsschichten auch ein größeres Prozessfenster bzw. eine größere Toleranz des Abscheideprozesses gegenüber Produktionsschwankungen in der Komposition der auf den metamorphen Puffer abgeschiedenen Schichten.

In einer Weiterbildung sind die Dicken der Anzahl N der Kompensationsschichten insgesamt d.h. in Summe größer als 150 nm. Untersuchungen haben gezeigt, dass sich mit einer Gesamtdicke oberhalb von 150 nm eine merkliche Kompensation der Verspannung des metamorphen Puffers durchführen lässt. Vorteilhaft ist es, wenn die Gitterkonstanten der jeweiligen Anzahl N der Kompensationsschichten um wenigstens um einen Betrag von $\Delta A_N > 0{,}002$ Å kleiner als die erste Gitterkonstante sind. Untersuchungen haben gezeigt, dass mit von $\Delta A_N < 0{,}002$ Å eine so hohe Gesamtdicke der Kompensationsschichten zur Realisierung einer möglichst hohen Kompensation notwendig ist, dass die Wirtschaftlichkeit der Herstellung der Solarzelle signifikant negativ beeinflusst ist.

In einer alternativen Ausführungsform ist der Betrag $\Delta A_N < 0{,}002$ Å, wobei die Spannungskompensationsschichten gleichzeitig als Schichten eines Halbleiter- oder Braggspiegels ausgebildet sind. Anders ausgedrückt, weisen hierbei die Spannungskompensationsschichten eine Doppelfunktion auf.

In einer anderen Ausführungsform zeigte sich, dass die Dicken der Anzahl N der Kompensationsschichten so gewählt sind, dass gilt:

$$\sum_{n=1}^{N} \left( KOMD_n \times \Delta A_n \right) > 2 * 10^{-19} \, m^2$$

Insbesondere mit einer Vergrößerung in der Differenz der Gitterkonstanten lassen sich hierdurch mit Schichtdicken unterhalb 1 μm eine wenigstens 20 % Kompensation des hautsächlich durch den Puffer erzeugten tensilen Stresses erzielen.

In einer anderen Weiterbildung sind die Dicken der Anzahl N der Kompensationsschichten so gewählt sind, dass gilt

$$\sum_{n=1}^{N} \left( KOMD_n \times \Delta A_n \right) < 5 * 10^{-19} \, m^2$$

Untersuchungen haben gezeigt, dass oberhalb des Wertes die Wahrscheinlichkeit einer Rissbildung in den Kompensationsschichten stark steigt.

Erfindungsgemäß weisen die Kompensationsschichten jeweils eine tensile Verspannung auf, sodass die laterale Gitterkonstante (engl. in-plane lattice constant) der Kompensationsschicht größer als die vertikale Gitterkonstante (engl. out-of-plane lattice constant) ist. Mit der lateralen Gitterkonstante ist vorliegend die Gitterkonstante in Richtung der Haupterstreckungsfläche der Kompensationsschicht gemeint. Anders ausgedrückt weist die einzelne Kompensationsschicht jeweils eine anisotrope Gitterkonstante auf. In einer alternativen Ausführungsform weisen die Kompensationsschichten jeweils eine Verbindung aus GaAs oder GaInAs oder AlGaInAs oder GaInP oder AlGaInP oder GaAsP oder GaInAsP auf.

In einer Weiterbildung ist der Indium-Gehalt der Kompensationsschichten um 0,2% oder um 0,5% geringer als der Indium-Gehalt der ersten Teilzelle. Es versteht sich, dass die Höhe des Indiums-Gehalts einen wesentlichen Einfluss auf die Gitterkonstanten ausübt. Des Weiteren ist es vorteilhaft, einen Teil der Kompensationsschichten oder alle Kompensationsschichten mit Zn zu dotieren. Besonders vorteilhaft ist es, wenn die Zink-Dotierung größer $10^{14}$ cm$^{-3}$ beträgt.

In einer anderen Weiterbildung ist ein Teil der Kompensationsschichten oder alle Kompensationsschichten als Teil des Halbleiterspiegels ausgebildet. Vorteilhaft ist, dass mit der doppelten Funktionalität der Schichten sich die Gesamtdicke der Mehrfach-Solarzelle verringern lässt. In einer bevorzugten Ausführungsform weist die zweite Teilzelle Germanium auf. Ferner ist eine dritte Teilzelle vorgesehen, wobei die dritte Teilzelle eine Verbindung aus GaInP aufweist. Ferner ist es vorteilhaft zwischen der dritten Teilzelle und der ersten Teilzelle eine vierte Teilzelle auszubilden, wobei die vierte Teilzelle eine GaAs oder InGaAs oder eine AlGaInAs Verbindung umfasst.

Untersuchungen haben gezeigt, dass sich die Teilzellen sowohl in einer aufrechten Anordnung als auch in einer invertierten Anordnung ausbilden lassen. Hierbei wird unter der aufrechten Anordnung verstanden, dass die während des epitaktischen Herstellungsprozesses zuletzt abgeschiedene Teilzelle die oberste Teilzelle der Mehrfach-Solarzelle ist. Vorliegend wird unter der obersten Teilzelle diejenige Teilzelle verstanden, die der Sonne am nächsten angeordnet ist und die größte Bandlücke aller Teilzellen aufweist. Unter der invertierten Anordnung wird verstanden, dass die während des epitaktischen Herstellungsprozesses zuerst abgeschiedene Teilzelle die oberste Teilzelle der Mehrfach-Solarzelle ist. Anders ausgedrückt, weist im Falle der aufrechten Anordnung die erste Teilzelle mit der größeren Gitterkonstante eine größere Bandlücke als die Bandlücke der zweiten Teilzelle mit der kleineren Gitterkonstante auf. Im Falle der invertierten Anordnung weist die erste Teilzelle mit der größeren Gitterkonstante eine kleinere Bandlücke als die Bandlücke der zweiten Teilzelle mit der kleineren Gitterkonstante auf.

In einer anderen Ausführungsform sind bei einer Anordnung von vier Teilzellen jeweils zwei Teilzellenpaare ausgebildet, wobei zwischen den zwei Teilzellenpaaren eine stoffschlüssige Verbindung durch einen direkten Halbleiterbond besteht. Hierbei ist es besonders vorteilhaft, dass die Kompensation der Verspannung des Gitters erfolgt, da der Bondprozess nur eine geringe Toleranz gegenüber einer Verkrümmung der zusammenzufügenden Wafer bzw. Halbleiterscheiben aufweist. In einer Ausführungsform ist es besonders vorteilhaft, dass die Mehrfach-Solarzelle eine GaInP/GaAs/GaInAs/Ge Vierfach-Solarzelle ist, bestehend aus zwei durch einen direkten Halbleiterbond zusammengefügten Zweifach-Solarzellen, von denen eine eine aufrecht metamorphe GaInAs/Ge Zweifach-Solarzelle ist.

In einer anderen Ausführungsform ist ein zweiter oder dritter metamorpher Puffer ausgebildet, wobei mit den einzelnen Puffern jeweils weitere, d.h. zweite oder dritte Kompensationsschichten ausgebildet sind und jede der Kompensationsschichten zwischen einem metamorphen Puffer und der benachbarten Teilzelle mit der größeren Gitterkonstante ausgebildet ist. Des Weiteren sei anmerkt, dass die Kompensationsschichten nicht Teil eines p-n Übergangs einer Tunneldiode sind.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Darin zeigt:

Figur 1a    einen Querschnitt auf eine erste erfindungsgemäße Ausführungsform einer Mehrfach-Solarzelle,

Figur 1b    den Verlauf der Gitterkonstante, in Abhängigkeit der Schichtenfolge der Solarzellenstruktur dargestellt in der Figur 1a,

Figur 1c    den Verlauf der lateralen Gitterkonstante, in Abhängigkeit der Schichtenfolge der Solarzellenstruktur dargestellt in der Figur 1a,

Figur 1d    den Verlauf der vertikalen Gitterkonstante, in Abhängigkeit der Schichtenfolge der Solarzellenstruktur dargestellt in der Figur 1a,

Figur 2     einen Querschnitt auf eine zweite erfindungsgemäße Ausführungsform als eine Dreifach-Zelle,

Figur 3     einen Querschnitt auf eine dritte erfindungsgemäße Ausführungsform als eine Vierfach-Solarzelle.

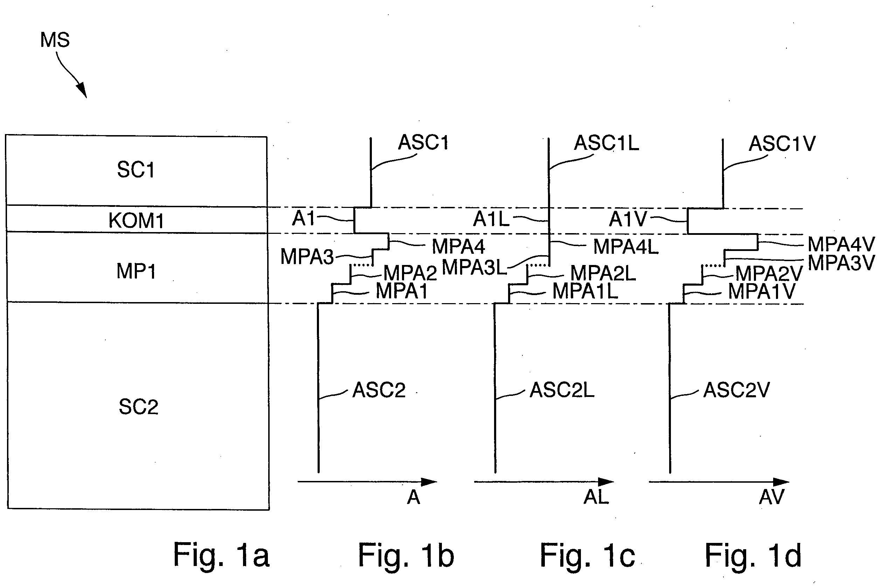

Die Abbildung der Figur 1a zeigt einen Querschnitt auf eine erste erfindungsgemäße Ausführungsform einer Mehrfach-Solarzelle MS mit einer ersten Teilzelle SC1. Die erste Teilzelle SC1 liegt auf einer einzigen Kompensationsschicht KOM1 auf. Es sei jedoch angemerkt, dass in einer nicht dargestellten alternativen Ausführungsform anstatt einer einzigen Kompensationsschicht eine Vielzahl von N einzelnen Kompensationsschichten ausgebildet ist. Ferner liegt die Kompensationsschicht KOM1 auf einem metamorphen Puffer MP1 auf, wobei der Puffer MP1 auf einer zweiten Teilzelle SC2 aufliegt. Der Puffer weist eine Abfolge von nicht dargestellten Schichten auf.

In der Abbildung der Figur 1b ist den Verlauf der Gitterkonstante A in Abhängigkeit der Schichtenfolge der Solarzellenstruktur, dargestellt in der Figur 1a, aufgetragen. Im Folgenden werden nur die Unterschiede zu der Abbildung der Figur 1a erläutert. Es sei angemerkt, dass vorliegend mit der Gitterkonstante A immer die sogenannte natürliche Gitterkonstante verstanden wird. Die zweite Teilzelle SC2 weist eine zweite Gitterkonstante ASC2 auf. Auf der zweiten Teilzelle SC2 ist eine Abfolge von einer ersten Schicht mit einer Gitterkonstante MPA1 und einer zweiten Schicht mit einer Gitterkonstante MPA2 und einer dritten Schicht mit einer Gitterkonstante MPA3 und eine vierte Schicht mit einer vierten Gitterkonstante MPA4 angeordnet. Es zeigt sich, dass die Gitterkonstanten MPA1, MPA2, MPA3 und MPA4 bei der Abfolge der Schichten von Schicht zu Schicht ansteigen, wobei alle Gitterkonstanten MPA1, MPA2, MPA3 und MPA4 der Abfolge größer sind, als die zweite Gitterkonstante ASC2. Des Weiteren ist die vierte Gitterkonstante MPA4 größer als die erste Gitterkonstante ASC1. Hierdurch wird die vierte Schicht auch als "overshoot" Schicht bezeichnet. Die Kompensationsschicht KOM1 weist eine kleinere Gitterkonstante A1 als die erste Gitterkonstante ASC1 auf. Es versteht sich, dass die "overshoot" Schicht kompressiv verspannt ist und eine Spannung auf die Halbleiterscheibe ausübt.

Erst mit der Einführung der Kompensationsschicht KOM1 und der Ausbildung einer im Vergleich mit der ersten Gitterkonstante ASC1 kleineren Gitterkonstante A1 lässt sich ein Ausgleich d.h. eine Reduktion der Gitterverspannung erzielen. Hierbei ist die Größe der Reduktion umso größer je höher die Dicke $KOMD_1$ der Kompensationsschicht KOM1 und je größer der Unterschied der Gitterkonstante A1 der Kompensationsschicht KOM1 im Vergleich zu der ersten Gitterkonstante ASC1 ist. Der Verlauf der Gitterverspannung wird nachfolgend anhand des Verlaufs einer lateralen (in-plane) Gitterkonstante AL und dem Verlauf einer vertikalen (out-of-plane) Gitterkonstante AV aufzeigen.

Die Abbildung der Figur 1c zeigt den Verlauf einer lateralen Gitterkonstante AL für die Schichtfolge der Solarzellenstruktur, dargestellt in der Figur 1a. Des Weiteren wird in der Abbildung der Figur 1d der Verlauf einer vertikalen Gitterkonstante AV für die Schichtfolge der Solarzellenstruktur, dargestellt in der Figur 1a, gezeigt. Im Folgenden werden nur die Unterschiede zu den Erläuterungen der vorangegangen Figuren angeführt. Es zeigt sich, dass aus dem Verlauf der lateralen Gitterkonstante AL und aus dem Verlauf der vertikalen Gitterkonstante AV der Verlauf der Gitterverspannung für die Solarzellenstruktur genauer ablesen lässt. Die zweite Teilzelle SC2 weist eine zweite laterale Gitterkonstante ASC2L auf. Auf der zweite Teilzelle SC2 ist die Abfolge von einer ersten Schicht mit einer lateralen Gitterkonstante MPA1L und einer zweiten Schicht mit einer lateralen Gitterkonstante MPA2L und einer dritten Schicht mit einer lateralen Gitterkonstante MPA3L und eine vierte Schicht mit einer vierten lateralen Gitterkonstante MPA4L ausgebildet, wobei die laterale Gitterkonstante MPA3L der dritten Schicht gleich groß ist wie die vierten lateralen Gitterkonstante MPA4L. Es zeigt sich, dass die lateralen Gitterkonstanten MPA1L, MPA2L und MPA3L bei der Abfolge der Schichten von Schicht zu Schicht ansteigen, wobei alle lateralen Gitterkonstanten MPA1L, MPA2L und MPA3L bzw. MPA4L der Abfolge größer sind, als die zweite laterale Gitterkonstante ASC2L. Nachfolgend weist die Kompensationsschicht KOM1 eine vierte laterale Gitterkonstante A1L und die erste Teilzelle SC1 eine erste laterale Gitterkonstante SC1L auf, wobei die vierte laterale Gitterkonstante A1L und die erste laterale Gitterkonstante SC1L und die laterale Gitterkonstante MPA3L und die laterale Gitterkonstante MPA4L der dritten Schicht und der vierten Schicht übereinstimmen.

Die zweite Teilzelle SC2 weist eine zweite vertikale Gitterkonstante ASC2V auf. Auf der zweiten Teilzelle SC2 ist eine Abfolge von einer ersten Schicht mit einer vertikalen Gitterkonstante MPA1V und einer zweiten Schicht mit einer vertikalen Gitterkonstante MPA2V und einer dritten Schicht mit einer vertikalen Gitterkonstante MPA3V und eine vierte Schicht mit einer vierten vertikalen Gitterkonstante MPA4V angeordnet. Es zeigt sich, dass die vertikalen Gitterkonstanten MPA1V, MPA2V, MPA3V und MPA4V bei der Abfolge der Schichten von Schicht zu Schicht ansteigen, wobei alle Gitterkonstanten MPA1V, MPA2V, MPA3V und MPA4V der Abfolge größer sind, als die zweite vertikale Gitterkonstante ASC2V. Des Weiteren weist die erste Teilzelle SC1 eine erste vertikale Gitterkonstante SC1AV auf, wobei die erste vertikale Gitterkonstante SC1AV größer ist als die zweite vertikale Gitterkonstante ASC2V. Ferner ist die vierte vertikale Gitterkonstante MPA4V größer als die erste vertikale Gitterkonstante ASC1V. Die Kompensationsschicht KOM1 weist jedoch eine kleinere vertikale Gitterkonstante A1V als die erste vertikale Gitterkonstante SCA1V auf. Im Vergleich von dem Verlauf der vertikalen Gitterkonstante AV mit dem Verlauf der Gitterkonstante A bedeutet dies, dass die Unterschiede in den vertikalen Gitterkonstante, sofern vorhanden, wesentlich größer sind als bei dem Verlauf der natürlichen Gitterkonstante A. Es wird angemerkt, dass die Restverspannung des metamorphen Puffers erfindungsgemäß durch eine oder mehrere Spannungskompensationsschichten zumindest teilweise kompensiert wird. Hierfür weist die Spannungskompensationsschicht eine Gitterkonstante auf die kleiner ist als die Gitterkonstante der ersten Teilzelle SC1. Weiterhin weist die Spannungskompensationsschicht eine tensile Verspannung bzw. Zugverspannung auf.

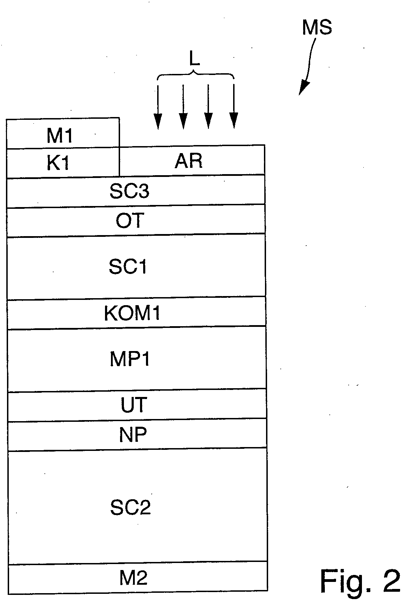

Die Abbildung der Figur 2 zeigt einen Querschnitt auf eine zweite erfindungsgemäße Ausführungsform in der Form einer Dreifach-Solarzelle, wobei ein Lichteinfall L durch eine Antireflexschicht AR stattfindet. Im Folgenden werden nur die Unterschiede zu der Abbildung der vorangegangenen Figuren erläutert. Die zweite Teilzelle SC2 ist vorzugsweise stoffschlüssig an der Unterseite mit einer Metallschicht M2 verbunden. Zwischen der zweiten Teilzelle SC2 und einer unteren Tunneldiode UT sind noch unterschiedliche Nukleationsschichten und / oder einfache Pufferschichten ausgebildet. Die obere Tunneldiode OT ist zwischen einer dritten Teilzelle SC3 und zwischen der ersten Teilzelle SC1 ausgebildet. Aufliegend auf der dritten Teilzelle SC3 ist eine Antireflexschicht AR und eine Kontaktvermittlungsschicht K1 und eine erste Metallschicht M1 angeordnet. Indem die untere Tunneldiode UT unter dem metamorphen Puffer MP1 liegt, bedeutet dies in Zusammenhang, dass ein n-auf-p Polarität aufweisender Solarzellenstapel ausgebildet wird, dass der metamorphe Puffer MP1 und die Spannungskompensationsschicht KOM1 positiv dotiert sind. Es ist bevorzugt, die Dreifach-Solarzelle als eine aufrecht metamorphe GaInP/GaInAs/Ge Dreifach-Solarzelle auszuführen. In einer nicht dargestellten Ausführungsform umfasst die Dreifach-Solarzelle einen Halbleiterspiegel. Vorzugsweise ist der Halbleiterspiegel zwischen der ersten Teilzelle SC1 und der zweiten Teilzelle SC2 ausgebildet.

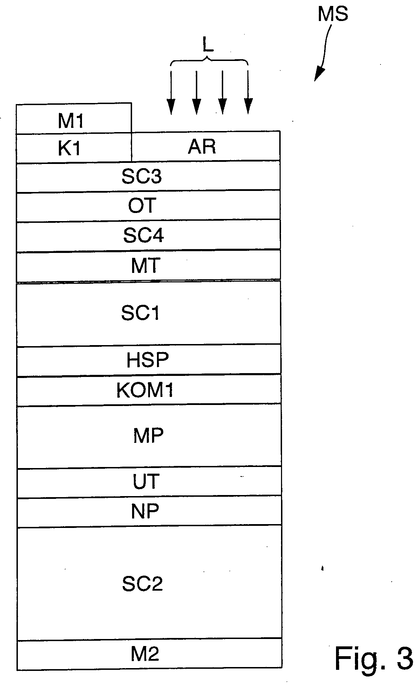

Die Abbildung der Figur 3 zeigt einen Querschnitt auf eine dritte erfindungsgemäße Ausführungsform in der Form einer Vierfach-Solarzelle. Im Folgenden werden nur die Unterschiede zu den Abbildungen der vorangegangenen Figuren erläutert. Vorzugsweise umfasst die Vierfach-Solarzelle eine Verbindungsfolge aus AlGaInP/AlGaInAs/GaInAs/Ge, wobei die Verbindung aus AlGaInP als oberste dem einfallenden Licht L zugewandten Teilzelle angeordnet ist. Zwischen der ersten Teilzelle SC1 und der Kompensationsschicht KOM1 ist ein Halbleiterspiegel HSP ausgebildet. Ferner ist zwischen der ersten Teilzelle SC1 und der der vierten Teilzelle SC4 eine mittlere Tunneldiode MT ausgebildet. Des Weiteren ist zwischen der ersten Teilzelle SC1 und der dritten Teilzelle SC3 eine vierte Teilzelle SC4 ausgebildet.

**Patentansprüche**

1. Mehrfach-Solarzelle (MS) aufweisend
eine erste Teilzelle (SC1) bestehend aus einer Verbindung aus InGaAs, wobei die erste Teilzelle (SC1) eine erste Gitterkonstante (ASC1) aufweist, und
eine zweite Teilzelle (SC2) mit einer zweiten Gitterkonstante (ASC2), wobei die erste Gitterkonstante (ASC1) um mindestens 0,008 Ä größer ist als die zweite Gitterkonstante (ASC2), und
jede Teilzelle (SC1, SC2) einen pn Übergang aufweist, und
einen metamorphen Puffer (MP1), wobei der Puffer (MP1) zwischen der ersten Teilzelle (SC1) und der zweiten Teilzelle (SC2) ausgebildet ist und der Puffer (MP1) eine Abfolge von einer ersten Schicht mit einer ersten Gitterkonstanten (MPA1), einer zweiten Schicht mit einer zweiten Gitterkonstanten (MPA2) und mindestens einer dritten Schicht mit einer dritten Gitterkonstanten (MPA3) aufweist und die Gitterkonstanten (MPA1, MPA2, MPA3) der Abfolge in Richtung zu der ersten Teilzelle (SC1) von Schicht zu Schicht ansteigen und die Gitterkonstanten (MPA1, MPA2, MPA3) der Schichten des Puffers größer als die zweite Gitterkonstante (ASC2) sind,
wobei eine vierte Schicht des metamorphen Puffers eine vierte Gitterkonstante (MPA4) aufweist und die vierte Gitterkonstante (MPA4) größer als die erste Gitterkonstante (ASC1) ist, und wobei zwischen dem metamorphen Puffer (MP1) und der ersten Teilzelle (SC1) eine Anzahl N von Kompensationsschichten (KOM1, KOM2, .... KOMN) zur Kompensation der Restverspannung des metamorphen Puffers (MP1) ausgebildet sind und die Gitterkonstanten (A1, A2, .... AN) der jeweiligen Kompensationsschichten (KOM1, KOM2, .... KOMN) um einen Betrag von $\Delta A_N$ >0,0008 Å kleiner als die erste Gitterkonstante (ASC1) sind, die Kompensationsschichten (KOM1, KOM2, .... KOMN) jeweils eine tensile Verspannung aufweisen, und die Kompensationsschichten (KOM1, KOM2, .... KOMN) einen Indiumgehalt größer als 1% aufweisen, und die Dicken (KOMD$_1$, KOMD$_2$, .... KOMD$_N$) der Anzahl N der Kompensationsschichten (KOM1, KOM2, .... KOMN) so gewählt sind, dass gilt:

$$\sum_{n=1}^{N} \left( KOMD_n \times \Delta A_n \right) > 10^{-19} \, m^2$$

2. Mehrfach-Solarzelle (MS) nach Anspruch 1, **dadurch gekennzeichnet, dass** die Gesamtdicke (KOMD$_1$, KOMD$_2$, .... KOMD$_N$) der Anzahl N der Kompensationsschichten (KOM1, KOM2, .... KOMN) insgesamt größer als 150 nm sind.

3. Mehrfach-Solarzelle (MS) nach Anspruch 1 oder Anspruch 2, **dadurch gekennzeichnet, dass** die Gitterkonstanten (A$_1$, A$_2$, .... A$_N$) der jeweiligen Anzahl N der Kompensationsschichten (KOM1, KOM2, .... KOMN) um wenigstens um einen Betrag von $\Delta A_N$ >0,002 Å kleiner als die erste Gitterkonstante (ASC1) sind.

4. Mehrfach-Solarzelle (MS) nach einem der vorangegangenen Ansprüche, **dadurch gekennzeichnet, dass** die Dicken (KOMD$_1$, KOMD$_2$, .... KOMD$_N$) der Anzahl N der Kompensationsschichten (KOM1, KOM2, .... KOMN) so gewählt sind, dass gilt

$$\sum_{n=1}^{N} \left( KOMD_n \times \Delta A_n \right) > 2 * 10^{-19} \, m^2$$

5. Mehrfach-Solarzelle (MS) nach einem der vorangegangenen Ansprüche, **dadurch gekennzeichnet, dass** die Dicken (KOMD$_1$, KOMD$_2$, .... KOMD$_N$) der Anzahl N der Kompensationsschichten (KOM1, KOM2, .... KOMN) so gewählt sind, dass gilt

$$\sum_{n=1}^{N} \left( KOMD_n \times \Delta A_n \right) < 5 * 10^{-19} \, m^2$$

6. Mehrfach-Solarzelle (MS) nach einem der vorangegangenen Ansprüche, **dadurch gekennzeichnet, dass** die Kompensationsschichten (KOM1, KOM2, .... KOMN) jeweils eine Verbindung aus GaAs oder GaInAs oder AlGaInAs oder GaInP oder AlGaInP oder GaAsP oder GaInAsP aufweisen.

7. Mehrfach-Solarzelle (MS) nach einem der vorangegangenen Ansprüche, **dadurch gekennzeichnet, dass** der Indium-Gehalt die Kompensationsschichten (KOM1, KOM2, .... KOMN) um wenigstens 0,2% oder um wenigstens 0,5% geringer als der Indium-Gehalt der ersten Teilzelle (SC1) ist.

8. Mehrfach-Solarzelle (MS) nach einem der vorangegangenen Ansprüche, **dadurch gekennzeichnet, dass** ein Teil oder alle der Kompensationsschichten (KOM1, KOM2, .... KOMN) mit Zn dotiert sind.

9. Mehrfach-Solarzelle (MS) nach einem der vorangegangenen Ansprüche, **dadurch gekennzeichnet, dass** ein Teil der Kompensationsschichten (KOM1, KOM2, .... KOMN) als Teil eines Halbleiterspiegels ausgebildet sind.

10. Mehrfach-Solarzelle (MS) nach einem der vorangegangenen Ansprüche, **dadurch gekennzeichnet, dass** die zweite Teilzelle (SC2) Germanium enthält und eine dritte Teilzelle (SC3) vorgesehen ist und die dritte Teilzelle (SC3) eine Verbindung aus GaInP aufweist.

11. Mehrfach-Solarzelle (MS) nach Anspruch 11, **dadurch gekennzeichnet, dass** zwischen der dritten Teilzelle (SC3) und der ersten Teilzelle (SC1) eine vierte Teilzelle (SC4) ausgebildet ist und die vierte Teilzelle (SC4) eine GaAs oder InGaAs oder eine AlGaInAs Verbindung umfasst.

12. Mehrfach-Solarzelle (MS) nach einem der vorangegangenen Ansprüche, **dadurch gekennzeichnet, dass** die Teilzellen (SC1, SC2, SC3, SC4) in einer aufrechten Anordnung oder in einer invertierten Anordnung ausgebildet sind.

13. Mehrfach-Solarzelle (MS) nach Anspruch 12, **dadurch gekennzeichnet, dass** bei dem Solarzellenstapels mit vier Teilzellen (SC1, SC2, SC3, SC4) jeweils zwei Teilzellenpaare (SC1, SC2, SC3, SC4) ausgebildet sind und die zwei Teilzellenpaare (SC1, SC2, SC3, SC4) eine stoffschlüssige Verbindung, mittels einem direkten Halbleiterbond ausbilden.

14. Mehrfach-Solarzelle (MS) nach einem der vorangegangenen Ansprüche, **dadurch gekennzeichnet, dass** ein zweiter metamorphe Puffer ausgebildet ist und mit dem zweiten Puffer eine zweite Anzahl von Kompensationsschichten ausgebildet ist.

15. Mehrfach-Solarzelle (MS) nach einem der vorangegangenen Ansprüche, **dadurch gekennzeichnet, dass** die Kompensationsschichten nicht Teil eines pn-Übergangs einer Tunneldiode sind.

16. Mehrfach-Solarzelle (MS) nach einem der vorangegangenen Ansprüche, **dadurch gekennzeichnet, dass** die Anzahl N die Menge der natürlichen Zahlen ohne die Null umfasst.

**Claims**

1. Multiple solar cell (MS) comprising
a first part cell (SC1) consisting of a compound of InGaAs, wherein the first part cell (SC1) has a first lattice constant (ASC1), and
a second part cell (SC2) with a second lattice constant (ASC2).
wherein the first lattice constant (ASC1) is greater by at least 0.0008 Å than the second lattice constant (ASC2) and each part cell (SC1, SC2) has a pn transition, and
a metamorphic buffer (MP1), wherein the buffer (MP1) is formed between the first part cell (SC1) and the second part cell (SC2) and the buffer (MP1) comprises a sequence of a first layer with a first lattice constant (MPA1), a second layer with a second lattice constant (MPA2) and at least a third layer with a third lattice constant (MPA3) and the lattice constants (MPA1, MPA2, MPA3) of the sequence increase from layer to layer in direction towards the first part cell (SC1) and the lattice constants (MPA1, MPA2, MPA3) of the layers of the buffer are greater than the second lattice constant (ASC2),
wherein a fourth layer of the metamorphic buffer has a fourth lattice constant (MPA4) and the fourth lattice constant (MPA4) is greater than the first lattice constant (ASC1), and wherein a number N of compensation layers (KOM1, KOM2, ... KOMN) for compensation for the residual voltage of the metamorphic buffer (MP1) is formed between the metamorphic buffer (MP1) and the first part cell (SC1) and the lattice constants (A1, A2, ... AN) of the respective compensation layers (KOM1, KOM2, ... KOMN) are smaller by an amount of $\Delta A_N > 0.0008$ Å than the first lattice constant (ASC1), the compensation layers (KOM1, KOM2, ... KOMN) each have an tensile bracing and the compensation layers (KOM1, KOM2, ... KOMN) have an indium content greater than 1%, and the thicknesses ($KOMD_1$, $KOMD_2$, ... $KOMD_N$) of the number N of the compensation layers (KOM1, KOM2, ... KOMN) are so selected that:

$$\sum_{n-1}^{N} (KOMD_n \; x \; \Delta A_n) > 10^{-19} m^2$$

.

2. Multiple solar cells (MS) according to claim 1, **characterised in that** the overall thickness ($KOMD_1$, $KOMD_2$, ... $KOMD_N$) of the number N of the compensation layers (KOM1, KOM2, ... KOMN) is greater in total than 150 nm.

3. Multiple solar cell (MS) according to claim 1 or claim 2, **characterised in that** the lattice constants ($A_1$, $A_2$, ... $A_N$) of the respective number N of the compensation layers (KOM1, KOM2, ... KOMN) are smaller by at least an amount of $\Delta A_N > 0.002$ Å than the first lattice constant (ASC1).

4. Multiple solar cell (MS) according to any one of the preceding claims, **characterised in that** the thicknesses ($KOMD_1$, $KOMD_2$, ... $KOMD_N$) of the number N of the compensation layers (KOM1, KOM2, ... KOMN) are so selected that:

$$\sum_{n-1}^{N} (KOMD_n \; x \; \Delta A_n) > 2 * 10^{-19} m^2$$

.

5. Multiple solar cell (MS) according to any one of the preceding claims, **characterised in that** the thicknesses ($KOMD_1$, $KOMD_2$, ... $KOMD_N$) of the number N of the compensation layers (KOM1, KOM2, ... KOMN) are so selected that:

$$\sum_{n-1}^{N} (KOMD_n \; x \; \Delta A_n) > 5 * 10^{-19} m^2$$

6. Multiple solar cell (MS) according to any one of the preceding claims, **characterised in that** the compensation layers (KOM1, KOM2, ... KOMN) each comprise a compound of GaAs or GaInAs or AlGaInAs or GaInP or AlGaInP or GaAsP or GaInAsP.

7. Multiple solar cell (MS) according to any one of the preceding claims, **characterised in that** the indium content of the compensation layers (KOM1, KOM2, ... KOMN) is smaller by at least 0.2% or by at least 5% than the indium content of the first part cell (SC1).

8. Multiple solar cell (MS) according to any one of the preceding claims, **characterised in that** a part or all of the compensation layers (KOM1, KOM2, ... KOMN) is or are doped with Zn.

9. Multiple solar cell (MS) according to any one of the preceding claims, **characterised in that** a part of the compensation layers (KOM1, KOM2, ... KOMN) is formed as part of semiconductor mirror.

10. Multiple solar cell (MS) according to any one of the preceding claims, **characterised in that** the second part cell (SC2) contains germanium and a third part cell (SC3) is provided and the third part cell (SC3) comprises a compound of GaInP.

11. Multiple solar cell (MS) according to claim 11, **characterised in that** a fourth part cell (SC4) is formed between the third part cell (SC3) and the first part cell (SC1) and the fourth part cell (SC4) comprises a GaAs or an InGaAs or an AlGaInAs compound.

**12.** Multiple solar cell (MS) according to any one of the preceding claims, **characterised in that** the part cells (SC1, SC2, SC3, SC4) are formed in an upright arrangement or in an inverted arrangement.

**13.** Multiple solar cell (MS) according to claim 12, **characterised in that** in the case of the solar cell stack with four part cells (SC1, SC2, SC3, SC4) two respective part cell pairs (SC1, SC2, SC3, SC4) are formed and the two part cell pairs (SC1, SC2, SC3, SC4) form a material-coupled composite by means of a direct semiconductor bond.

**14.** Multiple solar cell (MS) according to any one of the preceding claims, **characterised in that** a second metamorphic buffer is formed and a second number of compensation layers is formed by the second buffer.

**15.** Multiple solar cell (MS) according to any one of the preceding claims, **characterised in that** the compensation layers are not part of a pn transition of a tunnel diode.

**16.** Multiple solar cell (MS) according to any one of the preceding claims, **characterised in that** the number N comprises the plurality of natural numbers without zero.

**Revendications**

**1.** Cellule solaire à jonctions multiples (MS), présentant
une première cellule partielle (SC1) se composant d'un composé en InGaAs, dans laquelle la première cellule partielle (SC1) présente une première constante de réseau (ASC1) et
une deuxième cellule partielle (SC2) avec une deuxième constante de réseau (ASC2), dans laquelle la première constante de réseau (ASC1) est plus élevée d'au moins 0,008 Å que la deuxième constante de réseau (ASC2) et chaque cellule partielle (SC1, SC2) présente une jonction pn et
un tampon métamorphe (MP1), dans laquelle le tampon (MP1) est formé entre la première cellule partielle (SC1) et la deuxième cellule partielle (SC2) et le tampon (MP1) présente une succession d'une première couche avec une première constante de réseau (MPA1), une deuxième couche avec une deuxième constante de réseau (MPA2) et au moins une troisième couche avec une troisième constante de réseau (MPA3) et les constantes de réseau (MPA1, MPA2, MPA3) de la succession augmentent de couche en couche en direction de la première cellule partielle (SC1) et les constantes de réseau (MPA1, MPA2, MPA3) des couches du tampon sont plus élevées que la deuxième constante de réseau (ASC2),
dans laquelle une quatrième couche du tampon métamorphe présente une quatrième constante de réseau (MPA4) et la quatrième constante de réseau (MPA4) est plus élevée que la première constante de réseau (ASC1) et
dans laquelle un nombre N de couches de compensation (KOM1, KOM2, ..., KOMN) sont formées entre le tampon métamorphe (MP1) et la première cellule partielle (SC1) pour la compensation de la contrainte résiduelle du tampon métamorphe (MP1) et les constantes de réseau (A1, A2, ..., AN) des couches de compensation respectives (KOM1, KOM2, ..., KOMN) sont moins élevées d'un montant de $\Delta A_N > 0{,}0008$ Å que la première constante de réseau (ASC1), les couches de compensation (KOM1, KOM2, ..., KOMN) présentent respectivement une contrainte de traction, et les couches de compensation (KOM1, KOM2, ..., KOMN) présentent une teneur en Indium supérieure à 1 % et les épaisseurs ($KOMD_1$, $KOMD_2$, ..., $KOMD_N$) du nombre N des couches de compensation (KOM1, KOM2, ..., KOMN) sont choisies de telle manière que l'on ait :

$$\sum_{n=1}^{N} (KOMD_n \times \Delta A_n) > 10^{-19}\ m^2$$

**2.** Cellule solaire à jonctions multiples (MS) selon la revendication 1, **caractérisée en ce que** l'épaisseur totale ($KOMD_1$, $KOMD_2$, ..., $KOMD_N$) du nombre N des couches de compensation (KOM1, KOM2, ..., KOMN) est au total supérieure à 150 nm.

**3.** Cellule solaire à jonctions multiples (MS) selon une revendication 1 ou 2, **caractérisée en ce que** les constantes de réseau ($A_1$, $A_2$, ..., $A_N$) du nombre respectif N des couches de compensation (KOM1, KOM2, ..., KOMN) sont moins élevées d'au moins un montant de $\Delta A_N > 0{,}002$ Å que la première constante de réseau (ASC1).

**4.** Cellule solaire à jonctions multiples (MS) selon l'une quelconque des revendications précédentes, **caractérisée en ce que** les épaisseurs ($KOMD_1$, $KOMD_2$, ..., $KOMD_N$) du nombre N des couches de compensation (KOM1, KOM2, ..., KOMN) sont choisies de telle manière que l'on ait :

$$\sum_{n=1}^{N} (KOMD_n \times \Delta A_n) > 2 * 10^{-19}\, m^2$$

**5.** Cellule solaire à jonctions multiples (MS) selon l'une quelconque des revendications précédentes, **caractérisée en ce que** les épaisseurs ($KOMD_1$, $KOMD_2$, ..., $KOMD_N$) du nombre N des couches de compensation (KOM1, KOM2, ..., KOMN) sont choisies de telle manière que l'on ait :

$$\sum_{n=1}^{N} (KOMD_n \times \Delta A_n) < 5 * 10^{-19}\, m^2$$

**6.** Cellule solaire à jonctions multiples (MS) selon l'une quelconque des revendications précédentes, **caractérisée en ce que** les couches de compensation (KOM1, KOM2, ..., KOMN) présentent respectivement un composé en GaAs ou GaInAs ou AlGaInAs ou GaInP ou AlGaInP ou GaAsP ou GaInAsP.

**7.** Cellule solaire à jonctions multiples (MS) selon l'une quelconque des revendications précédentes, **caractérisée en ce que** la teneur en Indium des couches de compensation (KOM1, KOM2, ..., KOMN) est inférieure d'au moins 0,2 % ou d'au moins 0,5 % à la teneur en Indium de la première cellule partielle (SC1).

**8.** Cellule solaire à jonctions multiples (MS) selon l'une quelconque des revendications précédentes, **caractérisée en ce qu'**une partie ou la totalité des couches de compensation (KOM1, KOM2, ..., KOMN) sont dopées avec du Zn.

**9.** Cellule solaire à jonctions multiples (MS) selon l'une quelconque des revendications précédentes, **caractérisée en ce qu'**une partie des couches de compensation (KOM1, KOM2, ..., KOMN) sont formées comme une partie d'un miroir semi-conducteur.

**10.** Cellule solaire à jonctions multiples (MS) selon l'une quelconque des revendications précédentes, **caractérisée en ce que** la deuxième cellule partielle (SC2) contient du Germanium et il est prévu une troisième cellule partielle (SC3) et la troisième cellule partielle (SC3) présente un composé en GaInP.

**11.** Cellule solaire à jonctions multiples (MS) selon la revendication 11, **caractérisée en ce qu'**une quatrième cellule partielle (SC4) est formée entre la troisième cellule partielle (SC3) et la première cellule partielle (SC1) et la quatrième cellule partielle (SC4) comprend un composé en GaAs ou InGaAs ou AlGaInAs.

**12.** Cellule solaire à jonctions multiples (MS) selon l'une quelconque des revendications précédentes, **caractérisée en ce que** les cellules partielles (SC1, SC2, SC3, SC4) sont formées dans un agencement direct ou dans un agencement inversé.

**13.** Cellule solaire à jonctions multiples (MS) selon la revendication 12, **caractérisée en ce que** dans un empilement de cellules solaires avec quatre cellules partielles (SC1, SC2, SC3, SC4) sont formées chaque fois deux paires de cellules partielles (SC1, SC2, SC3, SC4) et les deux paires de cellules partielles (SC1, SC2, SC3, SC4) forment un assemblage matériel au moyen d'une liaison semi-conductrice directe.

**14.** Cellule solaire à jonctions multiples (MS) selon l'une quelconque des revendications précédentes, **caractérisée en ce que** l'on a formé un deuxième tampon métamorphe et, avec le deuxième tampon, on a formé un deuxième nombre de couches de compensation.

**15.** Cellule solaire à jonctions multiples (MS) selon l'une quelconque des revendications précédentes, **caractérisée en ce que** les couches de compensation ne font pas partie d'une jonction pn d'une diode tunnel.

**16.** Cellule solaire à jonctions multiples (MS) selon l'une quelconque des revendications précédentes, **caractérisée en ce que** le nombre N comprend la quantité des nombres naturels sans le zéro.

EP 2 919 276 B1

MS

| SC1 |
|---|
| KOM1 |
| MP1 |
| SC2 |

ASC1

A1

MPA3 — MPA4
MPA2
MPA1

ASC2

A

**Fig. 1a**

**Fig. 1b**

ASC1L

A1L

MPA4L
MPA3L
MPA2L
MPA1L

ASC2L

AL

**Fig. 1c**

ASC1V

A1V

MPA4V
MPA3V
MPA2V
MPA1V

ASC2V

AV

**Fig. 1d**

Fig. 2

MS

L

M1

K1 | AR

SC3

OT

SC4

MT

SC1

HSP

KOM1

MP

UT

NP

SC2

M2

Fig. 3

**EP 2 919 276 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2012240987 A1
- US 2012138130 A1
- EP 0353432 A2
- EP 2251912 A1
- EP 2650930 A1

**In der Beschreibung aufgeführte Nicht-Patentliteratur**

- **GUTER et al.** Current-matched triple-junction solar cell reaching 41.1% conversion efficiency under concentrated sunlight. *Applied Physics Letters,* 2009, vol. 94, 223504
- **BETT A. W. et al.** HIGHEST EFFICIENCY MULTI-JUNCTION SOLAR CELL FOR TERRESTRIAL AND SPACE APPLICATIONS. *Proceedings of the 24th European Photovoltaic Solar Energy Conference and Exhibition,* 21. September 2009, ISBN 978-3-9363338-25-6, 1-6
- 0.7-eV GaInAs junction for a GaInP/GaAs/GaInAs(1eV)/GaInAs(0.7eV) four-junction solar cell. **FRIEDMAN D J et al.** Conference record of the 2006 IEEE 4th world conference on photovoltaic energy conversion. IEEE, Mai 2006, 598-602
- Metamorphic GayIn1-yP/Ga1-xInxAs tandem solar cells for space and for terrestrial concentrator applications at C > 1000 suns, Progress in Photovoltaics. **DIMROTH F. et al.** Research and Applications. John Wiley & Sons, LTD, Mai 2001, vol. 9, 165-178
- **TAKUO SASAKI et al.** Real-Time structural 1,6 Analysis of compositionally graded InGaAs / GaAs (0 0 1) Layers. *IEEE Journal of photovoltaics,* 30. Januar 2012, vol. 2 (1), ISSN 2156-3381, 35-40
- **W. GUTER et al.** Investigation and development of III-V triple-junction concentrator solar cells. *Proceedings of the 22nd European Photovoltaic Solar Energy Conference,* 2007, ISBN 978-3-936338-22-5, 122-125
- **JAN SCHÖNE.** *Kontrolle von Spannungsrelaxation und Defektbildung in metamorphen III-V Halbleiterheterostrukturen für hocheffiziente Solarzellen,* 2009, 1-146
- Evolution of a 2.05 eV AlGaInP top sub-cell for 5 and 6J-IMM applications. **CORNFIELD et al.** Photovoltaic Specialists Conference (PVSC). IEEE, 2012, 2788-2791